(19) Europäisches Patentamt
European Patent Office
Office européen des brevets

(11) **EP 4 346 360 B1**

(12) **EUROPEAN PATENT SPECIFICATION**

(45) Date of publication and mention
of the grant of the patent:
**18.06.2025 Bulletin 2025/25**

(51) International Patent Classification (IPC):
***H10N 30/00*** (2023.01)  ***H10N 30/50*** (2023.01)
***H10N 30/853*** (2023.01)

(21) Application number: **23198032.7**

(52) Cooperative Patent Classification (CPC):
**H10N 30/8554; H10N 30/50; H10N 30/704**

(22) Date of filing: **18.09.2023**

(54) **PIEZOELECTRIC ELEMENT AND ACTUATOR**

PIEZOELEKTRISCHES ELEMENT UND AKTUATOR

ÉLÉMENT PIÉZOÉLECTRIQUE ET ACTIONNEUR

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **30.09.2022 JP 2022158871**

(43) Date of publication of application:
**03.04.2024 Bulletin 2024/14**

(73) Proprietor: **FUJIFILM Corporation
Tokyo 106-8620 (JP)**

(72) Inventors:
• **KOBAYASHI, Hiroyuki
No. 577, Ushijima, Kaisei-machi, Ashigarakami-gun,
Kanagawa, 258-8577 (JP)**
• **NAKAMURA, Seigo
No. 577, Ushijima, Kaisei-machi, Ashigarakami-gun,
Kanagawa, 258-8577 (JP)**
• **SUGIMOTO, Shinya
No. 577, Ushijima, Kaisei-machi, Ashigarakami-gun,
Kanagawa, 258-8577 (JP)**
• **SASAKI, Tsutomu
No. 577, Ushijima, Kaisei-machi, Ashigarakami-gun,
Kanagawa, 258-8577 (JP)**

(74) Representative: **HGF
HGF Limited
1 City Walk
Leeds LS11 9DX (GB)**

(56) References cited:
**WO-A1-2007/112741    JP-A- 2013 080 887
JP-A- 2017 130 701**

**Description**

BACKGROUND

1. Technical Field

The present disclosure relates to a piezoelectric element and an actuator.

2. Related Art

As a material having excellent piezoelectric characteristics and excellent ferroelectricity, there is known a perovskite-type oxide such as lead zirconate titanate ($Pb(Zr,Ti)O_3$, hereinafter referred to as PZT). A piezoelectric body consisting of a perovskite-type oxide is applied as a piezoelectric film in a piezoelectric element comprising a lower electrode, a piezoelectric film, and an upper electrode on a substrate. This piezoelectric element has been developed into various devices such as a memory, an inkjet head (an actuator), a micromirror device, an angular velocity sensor, a gyro sensor, a piezoelectric micromachined ultrasonic transducer (PMUT), and an oscillation power generation device.

As the piezoelectric element, in order to obtain high piezoelectric characteristics, a multilayered piezoelectric element in which a plurality of piezoelectric films are laminated via an electrode layer has been proposed.

For example, JP2013-80886A proposes a piezoelectric element in which a first electrode, a Nb-doped PZT film, a second electrode, a Nb-doped PZT film, and a third electrode are laminated in this order. It is known that the Nb-doped PZT film has a direction of a spontaneous polarization that is aligned upward with respect to the substrate during film formation. That is, both of two layers of Nb-doped PZT films in JP2013-80886A have a spontaneous polarization of which a direction is aligned upward. In general, for the piezoelectric film having the spontaneous polarization of which a direction is aligned, higher piezoelectric performance can be obtained by applying an electric field in the same direction as the direction of the spontaneous polarization. Therefore, in JP2013-80886A, the electric field in the same direction as the direction of the spontaneous polarization is applied to each of two Nb-doped PZT films by a first driving method in which a second electrode is grounded, a positive voltage (+V) is applied to a first electrode, and a negative voltage (-V) is applied to a third electrode, a second driving method in which the first electrode is grounded, a negative voltage (-V) is applied to the second electrode, and a negative voltage (-2V) that is larger in absolute value than that of the second electrode is applied to the third electrode, or the like. As a result, a displacement amount that is substantially twice that of the piezoelectric element having only one layer is realized.

Further, JP2013-80887A proposes a piezoelectric element in which a first electrode, a first piezoelectric film, a second electrode, a second piezoelectric film, and a third electrode are laminated in this order, and a direction in which a spontaneous polarization of the first piezoelectric film is aligned and a direction in which a spontaneous polarization of the second piezoelectric film is aligned are different from each other. Further, as a specific example, a case where the first piezoelectric film is a Nb-doped PZT film and the second piezoelectric film is a PZT film without Nb addition (hereinafter, referred to as pure PZT) is illustrated. The Nb-doped PZT film has a direction of the spontaneous polarization which is aligned in a state in which a poling treatment is not performed, and the pure PZT film has a direction of the spontaneous polarization which is not aligned in a state in which the poling treatment is not performed. Therefore, by performing the poling treatment on the pure PZT film such that the spontaneous polarization is aligned in a direction opposite to the direction of the spontaneous polarization of the Nb-doped PZT film, the direction of the spontaneous polarization of the first piezoelectric film and the direction of the spontaneous polarization of the second piezoelectric film are made different. In JP2013-80887A, by setting the first electrode and the third electrode of the piezoelectric element to have the same potential and using the second electrode as a drive electrode, an electric field in the same direction as the direction of the spontaneous polarization is applied to each of the first piezoelectric film and the second piezoelectric film. Accordingly, piezoelectric performance corresponding to two layers of piezoelectric films can be obtained with a voltage large enough to drive one layer of piezoelectric film, so that high piezoelectric performance can be obtained at a low voltage.

WO 2007/112741 A1 describes a multilayer piezoelectric bending device comprising a primary region and a secondary region, wherein one of the regions is polarized perpendicular to the polarization of the other regions. JP2017-130701A describes a manufacturing method of a piezoelectric element, in which an intermediate layer of the piezoelectric element is a diaphragm used in a wrap mode of wrapping and deforming in a film thickness direction.

SUMMARY

However, in JP2013-80886A, in order to obtain piezoelectric performance equivalent to that of the first driving method in the second driving method in which a voltage having an absolute value larger than that of the second electrode is applied to the third electrode, it is necessary to apply a very large voltage to the third electrode and sufficient piezoelectric performance cannot be obtained at a low voltage. In order to carry out the first driving method in which voltages of different signs are applied to the first electrode and the third electrode, it is necessary to provide a positive drive circuit and a negative drive circuit, which leads to high costs.

In addition, in the piezoelectric element of JP2013-80887A, very good piezoelectric performance can be obtained. However, in order to manufacture the piezoelectric element of JP2013-80887A, for example, the first piezoelectric film and the second piezoelectric film need to be composed of piezoelectric films containing different materials such that the first piezoelectric film is a Nb-doped PZT film and the second piezoelectric film is a pure PZT film. Therefore, in order to form the first piezoelectric film and the second piezoelectric film, two different targets are required, and at least one of the piezoelectric films needs to be subjected to the poling treatment, so that sufficient cost reduction cannot be achieved.

As described above, the piezoelectric element that can obtain high piezoelectric performance is expensive or requires application of a high voltage, and a low-cost piezoelectric element that can obtain high piezoelectric performance at a low voltage has not been realized.

An object of the present disclosure is to provide a piezoelectric element and a piezoelectric actuator capable of obtaining high piezoelectric performance at a low voltage at low costs.

A piezoelectric element according to an aspect of the present disclosure comprises a substrate; and a first electrode, a first piezoelectric film, a second electrode, a second piezoelectric film, and a third electrode which are provided on the substrate in this order, in which the first piezoelectric film and the second piezoelectric film contain a perovskite-type oxide represented by $Pb_a\{(Zr_xTi_{1-x})_{1-y}M_y\}O_3$, where M is a metal element selected from the group consisting of V, Nb, Ta, Sb, Mo, and W, and $0 < x < 1$, $0 < y < 1$, and $0.9 \leq a \leq 1.2$ are satisfied, as a main component, in the first piezoelectric film and the second piezoelectric film, at least x and y are the same, and one piezoelectric film of the first piezoelectric film and the second piezoelectric film has a spontaneous polarization aligned in a film thickness direction, and in a case where in a hysteresis curve showing polarization-voltage characteristics of the one piezoelectric film, a coercive voltage on a positive side is denoted by $Vcf^+$ and a coercive voltage on a negative side is denoted by $Vcf$, and in a hysteresis curve showing polarization-voltage characteristics of the other piezoelectric film of the first piezoelectric film and the second piezoelectric film, a coercive voltage on a positive side is denoted by $Vcr^+$ and a coercive voltage on a negative side is denoted by $Vcr^-$, $|Vcr^+ + Vcr^-| < |Vcf^+ + Vcf^-| - 0.2$, where units are all [V], is satisfied.

It is preferable that $|Vcr^+ + Vcr^-| \leq |Vcr^+ - Vcr^-|$ is further satisfied.

It is preferable that the other piezoelectric film may also have a spontaneous polarization aligned in the film thickness direction, and in this case, directions of the spontaneous polarizations of the one piezoelectric film and the other piezoelectric film are the same.

It is preferable that an electric field in the same direction as a direction of the spontaneous polarization of the one piezoelectric film is applied to the one piezoelectric film, and an electric field in a direction opposite to the electric field applied to the one piezoelectric film is applied to the other piezoelectric film.

It is preferable that a hysteresis width defined by an interval between two coercive voltages in the hysteresis curve showing polarization-voltage characteristics of the one piezoelectric film is equal to the hysteresis width of the other piezoelectric film.

It is preferable that where a (001) plane alignment degree of the one piezoelectric film is denoted by $\alpha$, a (001) plane alignment degree of the other piezoelectric film is $0.95\alpha$ or less.

It is preferable that where a (001) plane alignment degree of the one piezoelectric film is denoted by $\alpha$, a (001) plane alignment degree of the other piezoelectric film is $0.80\alpha$ or less.

It is preferable that the first electrode and the third electrode are connected to each other.

It is preferable that the metal element M is Nb and y is greater than 0.1.

An actuator according to another aspect of the present disclosure is an actuator comprising: the piezoelectric element according to the aspect of the present disclosure; and a drive circuit that applies a drive voltage to the piezoelectric element, in which the drive circuit applies an electric field in the same direction as a direction of the spontaneous polarization of the one piezoelectric film to the one piezoelectric film, and applies an electric field in a direction opposite to the electric field applied to the one piezoelectric film to the other piezoelectric film.

According to a technology of the present disclosure, it is possible to provide a piezoelectric element and an actuator capable of obtaining high piezoelectric performance at a low voltage at low costs.

BRIEF DESCRIPTION OF THE DRAWINGS

Fig. 1 is a cross-sectional view of a piezoelectric element according to one embodiment.
Fig. 2A is a diagram showing a polarization-voltage hysteresis curve of one piezoelectric film.
Fig. 2B is a diagram showing a polarization-voltage hysteresis curve of the other piezoelectric film.
Fig. 3 is a diagram showing a schematic configuration of an actuator.
Fig. 4 is a diagram showing a schematic configuration of an actuator of a modification example.

Fig. 5 is a diagram showing a schematic configuration of a piezoelectric element and an actuator of a modification example.

Fig. 6 is a cross-sectional view of a piezoelectric element of a modification example.

Fig. 7 is a diagram for explaining a problem of a multilayered piezoelectric element.

Fig. 8A is a hysteresis curve of a first piezoelectric film 14f.

Fig. 8B is a hysteresis curve of a second piezoelectric film 18f.

Fig. 8C is a diagram showing a displacement amount with respect to a voltage of a piezoelectric element 101.

Fig. 9 is an explanatory diagram of an effect of the piezoelectric element according to the present embodiment.

Fig. 10 is an explanatory diagram of an effect of a piezoelectric element according to the present embodiment.

Fig. 11 is a diagram showing a polarization-voltage hysteresis curve of the second piezoelectric film of Comparative Example 2.

Fig. 12 is a diagram showing a polarization-voltage hysteresis curve of the first piezoelectric film of Comparative Example 2.

Fig. 13 is a diagram showing a polarization-voltage hysteresis curve of the first piezoelectric film of Example 2.

Fig. 14 is a diagram showing a polarization-voltage hysteresis curve of the first piezoelectric film of Example 4.

Fig. 15 is a graph showing a voltage dependence of a piezoelectric constant $d_{31}$ in a low voltage region for the piezoelectric elements of Examples and Comparative Examples.

## DESCRIPTION OF EMBODIMENTS

Hereinafter, embodiments according to the present invention will be described with reference to the drawings. In the drawings below, a layer thickness of each of layers and a ratio therebetween are depicted with appropriate changes for easy visibility, and thus they do not necessarily reflect the actual layer thickness and ratio.

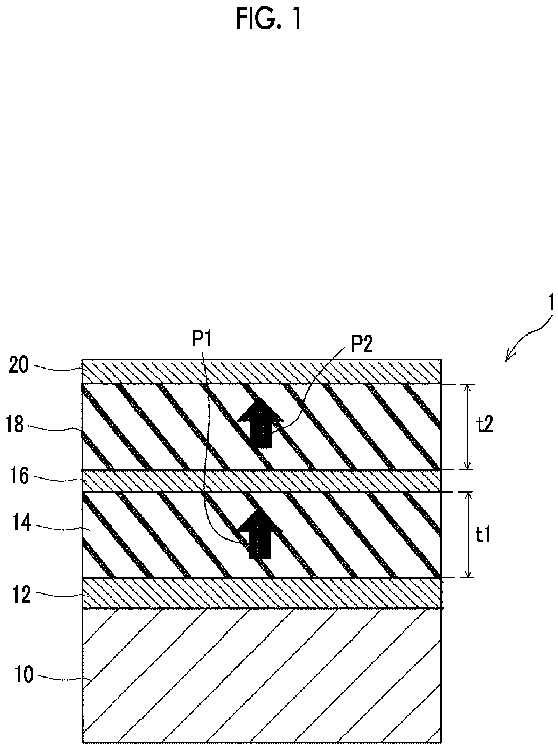

Fig. 1 is a cross-sectional schematic view showing a layer configuration of a piezoelectric element according to one embodiment. As shown in Fig. 1, a piezoelectric element 1 comprises a first electrode 12, a first piezoelectric film 14, a second electrode 16, a second piezoelectric film 18, and a third electrode 20 on a substrate 10 in this order.

The substrate 10 is not particularly limited, and examples thereof include silicon, glass, stainless steel, yttrium-stabilized zirconia, alumina, sapphire, silicon carbide, or other substrates. As the substrate 10, a laminated substrate such as a thermal oxide film-attached silicon substrate having a $SiO_2$ oxide film formed on a surface of a silicon substrate may be used. Further, as the substrate 10, a resin substrate such as polyethylene terephthalate (PET), polyethylene naphthalata (PEN), polyimide, and the like may be used.

The first electrode 12 is formed on the substrate 10. The main component of the first electrode 12 is not particularly limited, and examples thereof include metals such as gold (Au), platinum (Pt), iridium (Ir), ruthenium (Ru), titanium (Ti), molybdenum (Mo), tantalum (Ta), and aluminum (Al) or metal oxides, and combinations thereof. In addition, indium tin oxide (ITO), $LaNiO_3$, $SrRuO_3$ (SRO), or the like may be used.

The second electrode 16 is laminated on the first piezoelectric film 14, and the third electrode 20 is laminated on the second piezoelectric film 18. The first electrode 12 and the second electrode 16 are paired with each other to apply an electric field to the first piezoelectric film 14. In addition, the second electrode 16 and the third electrode 20 are paired with each other to apply an electric field to the second piezoelectric film 18.

The main components of the second electrode 16 and the third electrode 20 are not particularly limited, and examples thereof include, in addition to the materials exemplified for the first electrode 12, electrode materials that are generally used in a semiconductor process such as chromium (Cr) and combinations thereof. However, it is preferable to use an oxide conductor for the layer in contact with the first piezoelectric film 14 or the second piezoelectric film 18. Specific examples of an oxide conductor layer include indium tin oxide (ITO), Ir oxide, and $SrRuO_3$ (SRO), as well as $LaNiO_3$ and a doped ZnO.

The thicknesses of the first electrode 12, the second electrode 16, and the third electrode 20 are not particularly limited and are preferably about 50 nm to 300 nm, and more preferably 100 nm to 300 nm.

The first piezoelectric film 14 and the second piezoelectric film 18 have, as main components, perovskite-type oxides which are represented by General Formula $ABO_3$ and contain lead (Pb) at an A site, and zirconium (Zr), titanium (Ti), and a metal element M at a B site. This perovskite-type oxide is represented by the following general formula.

$$Pb_a\{(Zr_xTi_{1-x})_{1-y}M_y\}O_3$$

Here, the metal element M is preferably one or more elements selected from vanadium (V), niobium (Nb), tantalum (Ta), antimony (Sb), molybdenum (Mo), and tungsten (W). Here, $0 < x < 1$, $0 < y < 1$, and $0.9 \le a \le 1.2$ are satisfied. Hereinafter, $Pb_a\{(Zr_xTi_{1-x})_{1-y}M_y\}O_3$ will be referred to as M-doped PZT. In addition, for example, in a case where the metal element M is Nb, it is referred to as Nb-doped PZT.

The metal element M may be a single element such as V only or Nb only, or it may be a combination of two or three or more elements, such as a mixture of V and Nb or a mixture of V, Nb, and Ta. In a case where the metal element M is these elements, a very high piezoelectric constant can be realized in combination with Pb of the A site element.

In particular, $Pb_a\{(Zr_x Ti_{1-x})_{1-y}Nb_y\}O_3$ in which the metal element M is Nb is optimal. Here, in a case where y > 0.1, a higher piezoelectric constant can be obtained. In a case of forming a piezoelectric film by a vapor phase growth method such as sputtering using Nb-doped PZT in which M is Nb, a piezoelectric film having a very high piezoelectric constant having more aligned spontaneous polarization upward from the substrate 10 can be obtained. In this specification, with reference to the substrate 10, a direction away from the substrate 10 is defined as upward, and the substrate 10 side is defined as downward.

Here, the main component means a component that occupies 80 mol% or more. It is preferable that 90 mol% or more of each of the first piezoelectric film 14 and the second piezoelectric film 18 is occupied by the perovskite-type oxide, and it is more preferable that the first piezoelectric film 14 and the second piezoelectric film 18 are composed of the perovskite-type oxide (however, containing unavoidable impurities).

A Pb composition ratio a in the perovskite-type oxide is defined by a = Pb/(Zr + Ti + M) where element symbols each represent a molar ratio.

Similarly, a Zr composition ratio x at the B site of the perovskite-type oxide is x = Zr/(Zr + Ti), a Ti composition ratio 1-x = Ti/(Zr + Ti), and an M composition ratio y which is a compositional ratio of the metal element M at the B site is y = M/(Zr + Ti + M). Here, element symbols in the formula each represent a molar ratio.

In the piezoelectric element 1, the Zr composition ratios, the Ti composition ratios, and the M composition ratios in the perovskite oxides contained in the first piezoelectric film 14 and the second piezoelectric film 18 are the same. That is, in a case where, in the perovskite-type oxide in the first piezoelectric film 14, the Pb composition ratio is denoted by a1, the Zr composition ratio is denoted by x1, the M composition ratio is denoted by y1, and in the perovskite-type oxide in the second piezoelectric film 18, the Pb composition ratio is denoted by a2, the Zr composition ratio is denoted by x2, and the M composition ratio is denoted by y2, x1 and x2 are the same, and y1 and y2 are the same. Here, "same" means that they are equal within a range of a measurement error. The Pb composition ratios of the first piezoelectric film 14 and the second piezoelectric film 18 may be the same as or different from each other. As a method for measuring the composition, there are a plurality of analysis methods such as inductively coupled plasma (ICP) emission spectroscopy or X-ray fluorescence (XRF). For example, in a case where composition analysis is performed by XRF, a measurement error is about 0.005.

It is said that, in the PZT-based perovskite-type oxide, high piezoelectric characteristics are exhibited at a morphotropic phase boundary (MPB) and its vicinity. A Zr/Ti molar ratio of around 55/45 is the MPB composition, and in the above general formula, the MPB composition or its vicinity is preferable. The "MPB or its vicinity" refers to a region in which a phase transition occurs in a case where an electric field is applied to the piezoelectric film. Specifically, Zr:Ti (molar ratio) is preferably in a range of 45:55 to 55:45, that is, in a range of x = 0.45 to 0.55.

A film thickness of each of the first piezoelectric film 14 and the second piezoelectric film 18 is preferably 0.2 $\mu$m or more and 5 $\mu$m or less, and more preferably 1 $\mu$m or more. The film thicknesses of the first piezoelectric film 14 and the second piezoelectric film 18 may be the same as or different from each other. It is also preferable that with respect to the film thickness of one piezoelectric film, the film thickness of the other piezoelectric film is made relatively thin.

In this example, both the first piezoelectric film 14 and the second piezoelectric film 18 have spontaneous polarizations aligned in the film thickness direction, and the directions in which the spontaneous polarizations are aligned are the same. In the example shown in Fig. 1, the direction of the spontaneous polarization P1 of the first piezoelectric film 14 and the direction of the spontaneous polarization P2 of the second piezoelectric film 18 are both upward in the film thickness direction. Whether or not the spontaneous polarization in the piezoelectric film is aligned and the direction in which the spontaneous polarization is aligned can be confirmed by measuring a P-V hysteresis curve (or P-E hysteresis curve) showing polarization-voltage characteristics (or polarization-electric field characteristics) of the piezoelectric film.

In the piezoelectric film that has not been subjected to the poling treatment, the reason why the direction of the spontaneous polarization is aligned in a state in which an external electric field is not applied is thought to be due to generation of an electric field caused by distortion or defect of a crystal structure (hereinafter referred to as a spontaneous internal electric field) in the piezoelectric film. In a case of a piezoelectric film in which a spontaneous internal electric field is not generated in a state in which an external electric field is not applied, the P-E hysteresis curve (or P-V hysteresis curve) depicts a shape whose center coincides with an origin. On the other hand, in a case of a piezoelectric film in which a spontaneous internal electric field is generated, that is, a piezoelectric film in which the direction of the spontaneous polarization is aligned in a state in which the external electric field is not applied, the center of the hysteresis curve is deviated (shifted) from the origin because the direction of the spontaneous polarization is aligned with respect to the spontaneous internal electric field. In a case of the P-E hysteresis curve, assuming that the spontaneous internal electric field is Ei and the external electric field applied from the outside is Eo, an electric field of Ei + Eo is applied, so that the center of the hysteresis curve is shifted from the origin by an amount of the spontaneous internal electric field Ei. In a case of the P-V hysteresis curve, the center of the hysteresis curve is shifted from the origin by the product of Ei and the film thickness. Therefore, in a case where the center of the measured hysteresis curve is shifted from the origin, it can be considered that the spontaneous internal electric field is generated and the spontaneous polarization is aligned. The amount of shift of the center of the hysteresis curve from the origin is proportional to an alignment degree of the spontaneous polarization, and a larger shift amount means that the alignment degree of the spontaneous polarization is higher (the spontaneous internal electric field is larger). In addition, it is possible to specify the direction of the spontaneous polarization that is aligned by a shift direction of the hysteresis curve from the origin. In a case of the P-V hysteresis curve, the center of the hysteresis curve is defined as a midpoint between two coercive voltages described below.

Hereinafter, the term "direction of the spontaneous polarization" means the direction of the spontaneous polarization aligned by the spontaneous internal electric field.

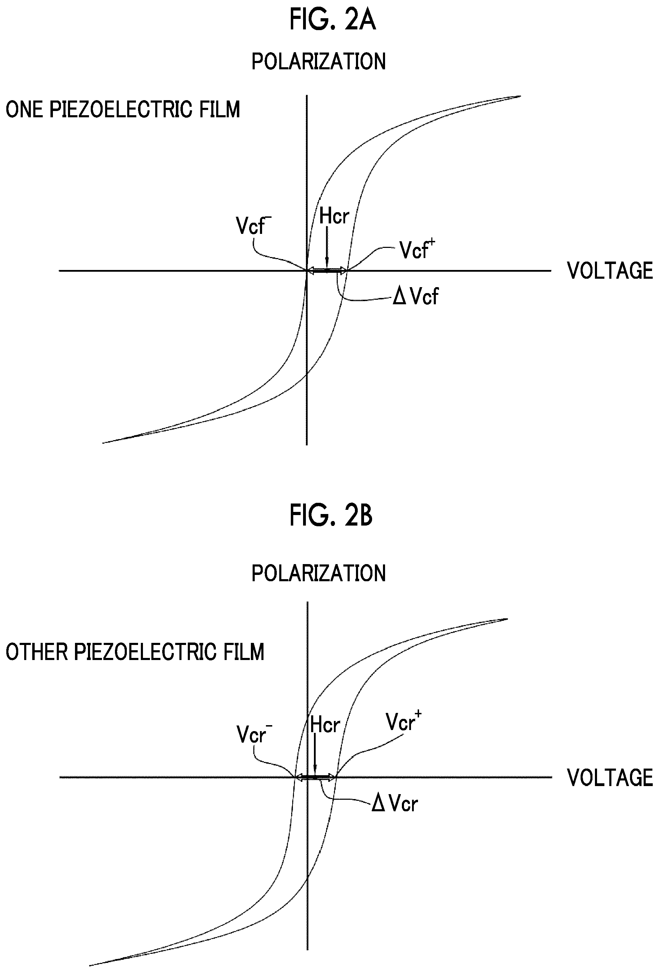

Fig. 2A shows a hysteresis curve of one piezoelectric film of the first piezoelectric film 14 and the second piezoelectric film 18. It is assumed that a coercive voltage on the positive side of the one piezoelectric film is $Vcf^+$ and a coercive voltage on the negative side of the one piezoelectric film is $Vcf^-$. Further, the larger of an absolute value of the coercive voltage $Vcf^+$ on the positive side and an absolute value of the coercive voltage $Vcf^-$ on the negative side is defined as a coercive voltage Vcf. In a case of Fig. 2A, Vcf is the coercive voltage $Vcf^+$ on the positive side.

Fig. 2B shows a hysteresis curve of the other piezoelectric film of the first piezoelectric film 14 and the second piezoelectric film 18. It is assumed that a coercive voltage on the positive side of the other piezoelectric film is $Vcr^+$, and a coercive voltage on the negative side of the other piezoelectric film is $Vcr^-$. Further, the larger of an absolute value of the coercive voltage $Vcr^+$ on the positive side and an absolute value of the coercive voltage $Vcr^-$ on the negative side is defined as a coercive voltage Ver. In a case of Fig. 2B, Vcr is the coercive voltage $Vcr^+$ on the positive side.

The coercive voltage is a voltage at which the polarization is zero in the hysteresis curve, and as shown in Figs. 2A and 2B, there are two coercive voltages in one hysteresis curve. The coercive voltage on the positive side refers to a coercive voltage on a relatively positive voltage side (right side in the figure) of the two negative voltages, and the coercive voltage on the negative side refers to a coercive voltage on a relatively negative voltage side (left side in the figure). Both the coercive voltage on the positive side and the coercive voltage on the negative side may be positive values, or the coercive voltage on the positive side may be a positive value and the coercive voltage on the negative side may be a negative value.

In this specification, an interval between the coercive voltage on the positive side and the coercive voltage on the negative side of the hysteresis curve is defined as a hysteresis width, and a midpoint of both is defined as a center of the hysteresis curve. Here, a distance between the center of the hysteresis curve and the origin is a shift amount of the hysteresis curve.

The piezoelectric element 1 satisfies

$$|Vcr^+ + Vcr^-| < |Vcf^+ + Vcf^-| - 0.2 \qquad (1).$$

The above expression (1) means that the shift amount of the hysteresis curve of the other piezoelectric film is smaller than the shift amount of the hysteresis curve of the one piezoelectric film. The center Hcf of the hysteresis curve of the one piezoelectric film is represented by $(Vcf^+ + Vcf^-)/2$. This is the shift amount of the hysteresis curve of the one piezoelectric film. The center Hcr of the hysteresis curve of the other piezoelectric film is represented by $(Vcr^+ + Vcr^-)/2$. This is the shift amount of the hysteresis curve of the other piezoelectric film. As shown in Figs. 2A and 2B, the coercive voltage is specified from the hysteresis measured for each piezoelectric film, and the measured value includes a measurement error of about $\pm 0.2$ V. Therefore, for example, a range of $| Vcf^+ + Vcf^-| \pm 0.2$ [V] is considered to be equivalent to $|Vcf^+ + Vcf^-|$. "- 0.2" on the right side of equation (1) takes the measurement error into account.

The first piezoelectric film 14 may be the one piezoelectric film showing the hysteresis curve of Fig. 2A, the second piezoelectric film 18 may be the other piezoelectric film showing the hysteresis curve of Fig. 2B, or conversely, the second piezoelectric film 18 may be the one piezoelectric film showing the hysteresis curve shown in Fig. 2A, and the first piezoelectric film 14 may be the other piezoelectric film showing the hysteresis curve shown in Fig. 2B.

It is preferable that the piezoelectric element 1 further satisfies $|Vcr^+ + Vcr^-| \leq |Vcr^+ - Vcr^-|$. The center of the hysteresis curve of the other piezoelectric film is represented by $(Vcr^+ + Vcr^-)/2$. Therefore, $|Vcr^+ + Vcr^-| \leq |Vcr^+ - Vcr^-|$ means that a distance between the center of the hysteresis curve and the origin is less than or equal to half the hysteresis width, that is, the hysteresis curve includes the origin.

In the example shown in Fig. 1, both the first piezoelectric film 14 and the second piezoelectric film 18 have spontaneous polarizations aligned in the film thickness direction, and the directions in which the spontaneous polarizations are aligned are the same. However, the first piezoelectric film 14 and the second piezoelectric film 18 need only satisfy a condition that the shift amount of the hysteresis curve of the other piezoelectric film is smaller than the shift amount of the hysteresis curve of the one piezoelectric film (equation (1) above). As described above, a smaller shift amount of the hysteresis curve means a smaller alignment degree of the spontaneous polarization. In the technology of the present disclosure, it is sufficient that the alignment degree of the spontaneous polarization of the other piezoelectric film is smaller than the alignment degree of the spontaneous polarization of the one piezoelectric film, so that the other piezoelectric film may be in a state in which the spontaneous polarization is not aligned, that is, the center of the hysteresis curve may substantially coincide with the origin.

Further, in the piezoelectric element 1 of this example, the hysteresis width defined by a difference between two coercive voltages in the hysteresis curve of the one piezoelectric film is equal to the hysteresis width in the hysteresis curve of the other piezoelectric film.

The hysteresis width of the one piezoelectric film is represented by $|Vcf^+ - Vcf^-|$, and the hysteresis width of the other piezoelectric film is represented by $|Vcr^+ - Vcr^-|$. The fact that $|Vcf^+ - Vcf^-|$ and $|Vcr^+ - Vcr^-|$ are equal means that they are equal within the range of measurement error. Therefore, within the range of $|Vcf^+ - Vcf^-| - 0.2 \leq |Vcr^+ - Vcr^-| \leq |Vcf^+ - Vcf^-| + 0.2$, the hysteresis widths of one piezoelectric film and the other piezoelectric film are considered to be equal.

Figs. 2A and 2B are hysteresis curves of one and the other piezoelectric films obtained by grounding the lower electrodes 12 and 16 of the piezoelectric films 14 and 18, using the upper electrodes 16 and 20 as drive electrodes, and applying a sweep voltage to the piezoelectric films 14 and 18. In this example, both the hysteresis curve of the first piezoelectric film 14 and the hysteresis curve of the second piezoelectric film 18 are shifted from the origin of the hysteresis curve in the same electric field direction (positive electric field direction in Figs. 2A and 2B). The hysteresis curves of one and the other piezoelectric films obtained by grounding the upper electrodes 16 and 20 of the piezoelectric films 14 and 18, using the lower electrodes 12 and 16 as drive electrodes, and applying a sweep voltage to the piezoelectric films 14 and 18 are obtained by rotating the hysteresis curves shown in Figs. 2A and 2B about the origin by 180°. In the measurement of the P-V characteristics of the first piezoelectric film 14 and the second piezoelectric film 18, either the upper electrode or the lower electrode may be used as the drive electrode.

As described above, the first piezoelectric film 14 and the second piezoelectric film 18 have a metal element M-doped PZT (hereinafter, referred to as M-PZT) in which at least the composition ratios other than the Pb composition ratios a are the same, as a main component. Further, in this example, the M-PZT film is preferentially aligned in a (001) plane. Examples of a method for realizing a configuration in which one of the first piezoelectric film 14 and the second piezoelectric film 18 has the hysteresis curve shown in Fig. 2A and the other piezoelectric film has the hysteresis curve shown in Fig. 2B include a method for changing (001) plane alignment degrees of the first piezoelectric film 14 and the second piezoelectric film 18. For example, in a case where the alignment degree of the second piezoelectric film 18 is denoted by $\alpha$, by setting the alignment degree of the first piezoelectric film 14 to $0.95\alpha$ or less, the second piezoelectric film 18 can be one piezoelectric film, and the first piezoelectric film 14 can be the other piezoelectric film. That is, the shift amount of the hysteresis curve can be made relatively small by relatively decreasing the alignment degree. The alignment degree of the other piezoelectric film is preferably $0.9\alpha$ or less, and more preferably $0.85\alpha$ or less, with respect to the alignment degree $\alpha$ of the one piezoelectric film. The method for measuring the (001) plane alignment degree will be described in Examples described later.

In a case where the alignment degree of one piezoelectric film is 0.95 times or less the alignment degree of the other piezoelectric film, the Pb composition ratios a may be the same or different. The alignment degrees can be made different by changing conditions for sputter-deposition of the first piezoelectric film 14 and the second piezoelectric film 18. For example, the same target is used as a target, and a substrate temperature during film formation is changed. The substrate temperature during film formation of the M-doped PZT is preferably in a range of about 550°C to 720°C. In this temperature range, a piezoelectric film having a high alignment degree can be obtained by forming a film at a relatively low substrate temperature, and a piezoelectric film having a low alignment degree can be obtained by forming a film at a relatively high substrate temperature. Therefore, for example, by forming the first piezoelectric film 14 at a relatively high substrate temperature, and then forming the second piezoelectric film 18 at a relatively low substrate temperature, the alignment degree of the first piezoelectric film 14 can be 0.95 times or less the alignment degree of the second piezoelectric film 18. In a case where the same target is used, the Pb composition ratio a changes as the substrate temperature is changed. A film formation at a relatively high substrate temperature results in a relatively low Pb composition ratio a, and a film formation at a relatively low substrate temperature results in a relatively high Pb composition ratio a. Therefore, in a case where the first piezoelectric film 14 and the second piezoelectric film 18 having different alignment degrees are formed using the same target, the Pb composition ratio a of the piezoelectric film having a high alignment degree is larger than the Pb composition a of the piezoelectric film having a low alignment degree. In addition, since Pb is likely to be removed during sputter-deposition, the Pb composition ratio in the target is set to be larger than a Pb composition ratio a = 1 of a stoichiometric ratio. In addition, it is preferable that the Pb composition ratio a in the first piezoelectric film 14 and the second piezoelectric film 18 after film formation is larger than 1. Further, the composition ratios other than Pb do not substantially change even in a case where the substrate temperature is changed.

Further, in a case where a target having a relatively large Pb composition ratio a is used as a target of the first piezoelectric film 14 deposited at a relatively high substrate temperature, and a target having a relatively small Pb composition ratio a is used as a target of the second piezoelectric film 18 deposited at a relatively low substrate temperature, compositions of the first piezoelectric film 14 and the second piezoelectric film 18 can be the same, and the alignment degree of the first piezoelectric film 14 can be lower than the alignment degree of the second piezoelectric film 18.

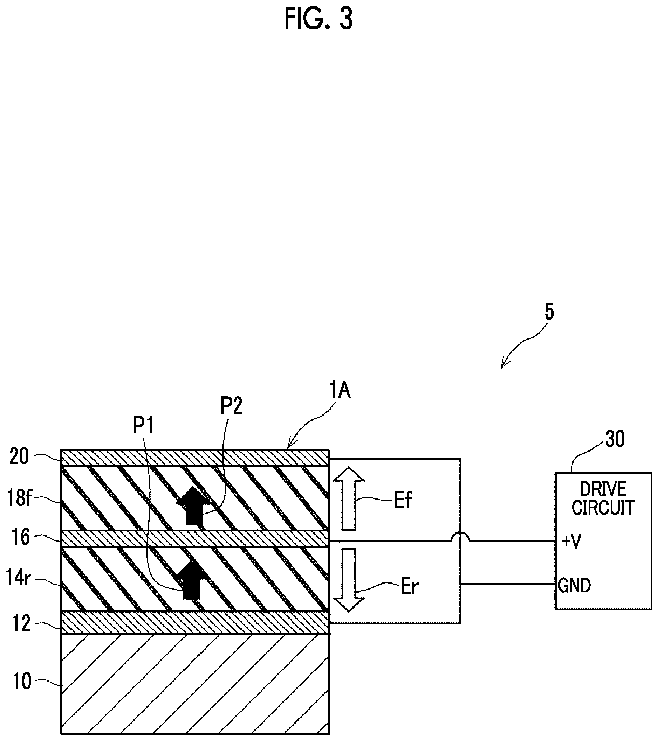

As described above, in the piezoelectric element 1, two layers of piezoelectric films containing M-doped PZT having the same composition ratios except for Pb are laminated with the electrode interposed therebetween, and the shift amount of the hysteresis curve of the other piezoelectric film is smaller than the shift amount of the hysteresis curve of the one piezoelectric film. With this configuration, in a case where the piezoelectric element 1 is driven by applying an electric field in the same direction as the direction of the spontaneous polarization to one piezoelectric film (first piezoelectric film 14 in the example of Fig. 3) and applying an electric field in a direction opposite to the electric field applied to the one piezoelectric film to the other piezoelectric film (second piezoelectric film 18 in the example of Fig. 3), good piezoelectric performance can be obtained in a low voltage region. Here, the low voltage region refers to a voltage region suitable for a case where the piezoelectric element is assumed to be incorporated in a consumer device, and specifically, a voltage region with an absolute value of 12 V or less. It is preferable that high piezoelectric performance can be obtained at a voltage of 7 V or less, and further 5 V or less.

As an example shown in Fig. 3, in a case where an electric field in the same direction as the direction of the spontaneous polarization P1 is applied to the first piezoelectric film 14, and an electric field in a direction opposite to the electric field applied to the first piezoelectric film 14 (that is, a direction opposite to the direction of the spontaneous polarization P2 in this example) is applied to the second piezoelectric film 18, a drive circuit having one polarity can be used for driving, so that it is possible to reduce the cost as compared with a case where two drive circuits having different polarities are provided. That is, in a case where the first electrode 12 and the third electrode 20 have the same pole and the second electrode 16 has a pole different from that of the first electrode 12 and the third electrode 20, the drive circuit having one polarity can be used for driving. In this case, electric fields in directions opposite to each other are applied to the first piezoelectric film 14 and the second piezoelectric film 18.

It is preferable that the piezoelectric element 1 is configured such that the first electrode 12 and the third electrode 20 are connected. In a case where the first electrode 12 and the third electrode 20 are connected, drive control is easy.

Since both the first piezoelectric film 14 and the second piezoelectric film 18 contain a perovskite-type oxide composed of M-doped PZT as a main component, the first piezoelectric film 14 and the second piezoelectric film 18 can be formed by using one target. In a case where the first piezoelectric film 14 and the second piezoelectric film 18 are formed with one target, cost reduction can be achieved.

Fig. 3 shows a schematic configuration of an actuator 5 comprising a piezoelectric element 1A. In addition, in the drawings after Fig. 3, the same components as those in Fig. 1 are designated by the same references. The actuator 5 includes the piezoelectric element 1A and a drive circuit 30. In the piezoelectric element 1A shown in Fig. 3, the first piezoelectric film 14r is the other piezoelectric film having the hysteresis curve of Fig. 2B, and the second piezoelectric film 18f is the one piezoelectric film having the hysteresis curve of Fig. 2A.

The drive circuit 30 is means for supplying a drive voltage to the piezoelectric film sandwiched between the electrodes. In this example, the first electrode 12 and the third electrode 20 are connected to a ground terminal of the drive circuit 30 and are set to a ground potential. The second electrode 16 is connected to a drive voltage output terminal of the drive circuit 30 and functions as a drive electrode. Accordingly, the drive circuit 30 applies drive voltages in directions opposite to each other to the first piezoelectric film 14r and the second piezoelectric film 18f. In this example, the drive circuit 30 is a positive drive circuit that executes a positive drive for applying a positive potential to the drive electrode in order to apply an electric field Ef in the same direction as the direction of the spontaneous polarization P2 to the second piezoelectric film 18f, which is the one piezoelectric film, and apply an electric field Er in a direction opposite to the electric field Ef applied to the second piezoelectric film 18f to the first piezoelectric film 14r, which is the other piezoelectric film.

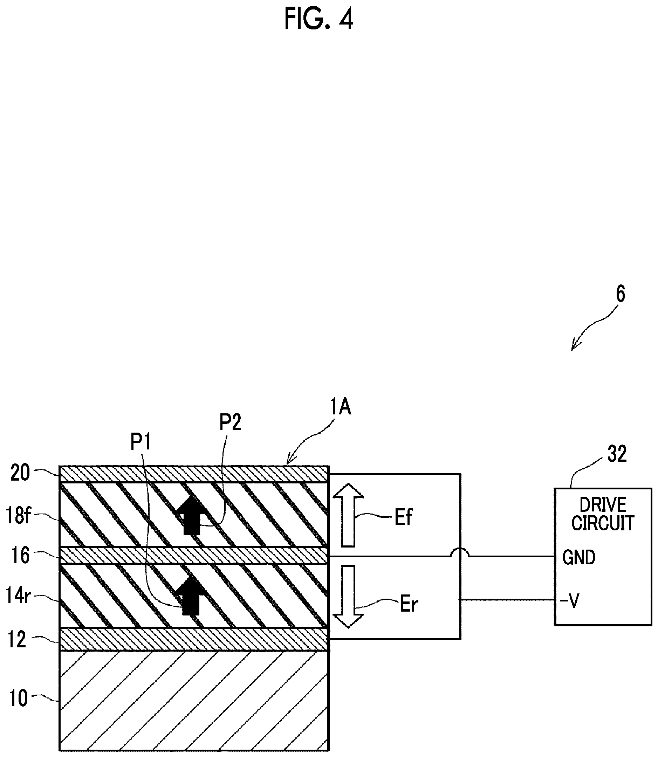

On the other hand, as in an actuator 6 of a modification example shown in Fig. 4, a drive circuit 32 that executes a negative drive for applying a negative potential to the drive electrode may be provided. In the example shown in Fig. 4, the second electrode 16 is connected to a ground terminal of the drive circuit 32 and is set to a ground potential. The first electrode 12 and the third electrode 20 are connected to a drive voltage output terminal of the drive circuit 32 and function as drive electrodes. In this case, since the drive circuit 32 is a negative drive circuit, the electric field Ef in the same direction as the direction of the spontaneous polarization P2 can be applied to the second piezoelectric film 18f, which is the one piezoelectric film, and the electric field Er in a direction opposite to the electric field Ef applied to the second piezoelectric film 18f can be applied to the first piezoelectric film 14r, which is the other piezoelectric film.

As described above, the actuators 5 and 6 comprising the piezoelectric element 1A need only be provided with a drive circuit having one polarity and can be realized at low costs. Since the piezoelectric element 1 is provided, large piezoelectric performance can be obtained in a low voltage region.

Further, as described above, the first piezoelectric film 14 may be the one piezoelectric film having the hysteresis curve shown in Fig. 2A and the second piezoelectric film 18 may be the other piezoelectric film having the hysteresis curve shown in Fig. 2B. The first piezoelectric film 14 having the hysteresis curve of Fig. 2A is assumed as a first piezoelectric film 14f, and the second piezoelectric film 18 having the hysteresis curve of Fig. 2B is assumed as a second piezoelectric film 18r.

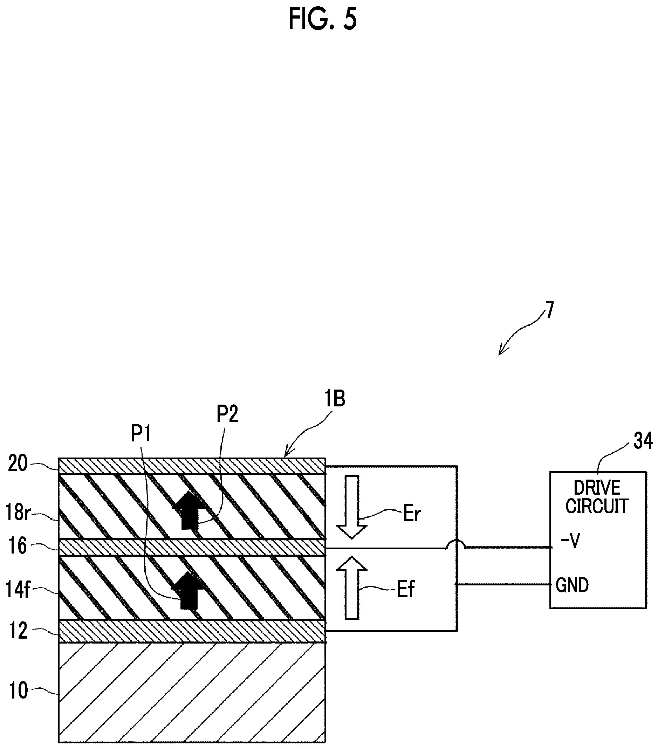

A piezoelectric element 1B shown in Fig. 5 comprises the first piezoelectric film 14f and the second piezoelectric film 18r. In this case, as shown in Fig. 5, by applying the electric field Ef in the same direction as the direction of the spontaneous polarization P1 to the first piezoelectric film 14f, which is the one piezoelectric film and applying the electric field Er in a direction opposite to the electric field Ef applied to the piezoelectric film 14f to the second piezoelectric film 18r, which is the other piezoelectric film, good piezoelectric performance can be obtained in a low voltage region by a drive circuit having one polarity.

In an actuator 7 shown in Fig. 5, the first electrode 12 and the third electrode 20 are connected to a ground terminal of a drive circuit 34 and are set to a ground potential. The second electrode 16 is connected to a drive voltage output terminal of the drive circuit 34 to function as a drive electrode. The drive circuit 34 is a negative drive circuit. In addition, a configuration may be adopted in which the piezoelectric element 1B and the positive drive circuit are provided, the second electrode 16 is connected to the ground terminal to be a ground potential, and the first electrode 12 and the third electrode 20 are connected to the drive voltage output terminal to function as a drive electrode.

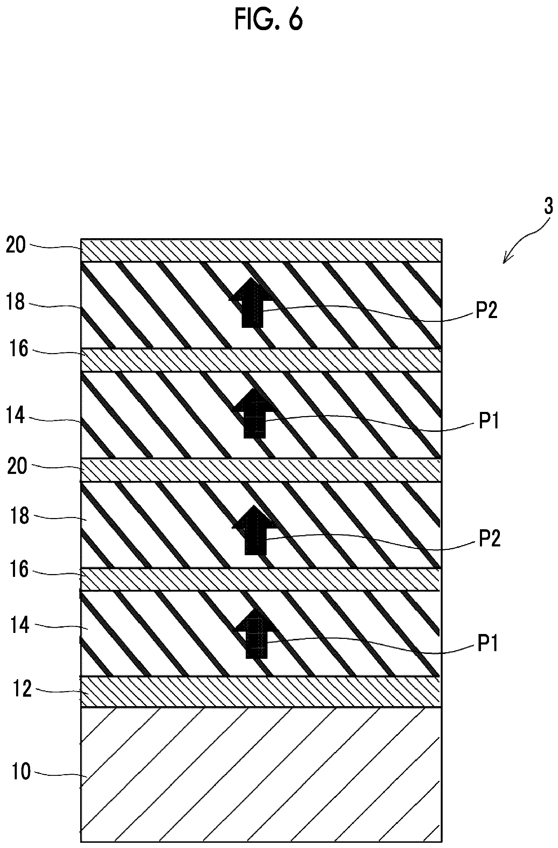

In addition, the piezoelectric element 1 shown in Fig. 1 is a two-layered piezoelectric element in which two layers of piezoelectric films including one first piezoelectric film 14 and one second piezoelectric film 18 are laminated. However, the piezoelectric element according to the present disclosure is not limited to two layers, and may include three or more layers of piezoelectric films. As in a piezoelectric element 3 shown in Fig. 6, a plurality of the first piezoelectric films 14 and a plurality of the second piezoelectric films 18 may be provided alternately. The piezoelectric element 3 has the first electrode 12, the first piezoelectric film 14, the second electrode 16, the second piezoelectric film 18, the third electrode 20, the first piezoelectric film 14, the second electrode 16, the second piezoelectric film 18, and the third electrode 20 which are laminated on the substrate 10 in this order. As described above, a plurality of layers of one piezoelectric film having the hysteresis curve shown in Fig. 2A and the other piezoelectric film having the hysteresis curve shown in Fig. 2B may be alternately provided via the electrodes.

Here, a principle in which the piezoelectric element 1 exhibits large piezoelectric performance in a low voltage region will be described.

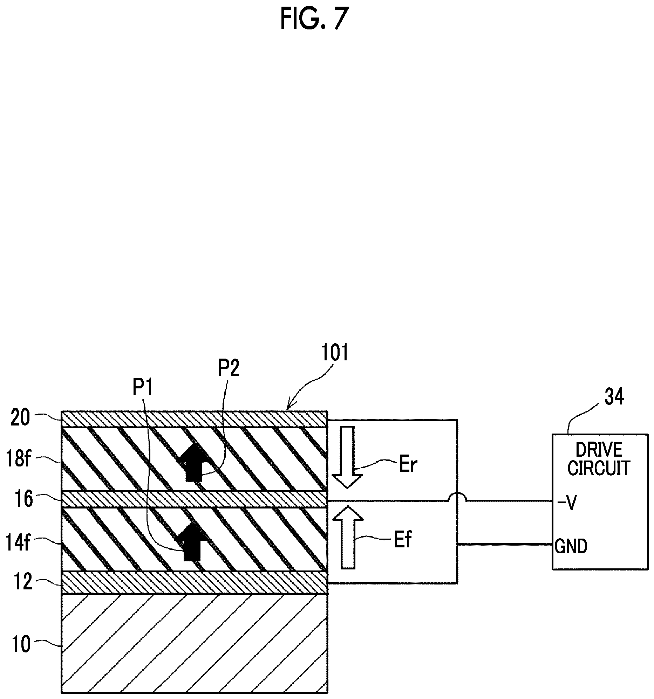

First, as shown in Fig. 7, piezoelectric performance of a piezoelectric element 101 in which a laminated structure is the same as that of the piezoelectric element 1 having a layer configuration shown in Fig. 1, but both the first piezoelectric film 14f and the second piezoelectric film 18f are piezoelectric films having the hysteresis curve shown in Fig. 2A will be described (see Comparative Example 2 below).

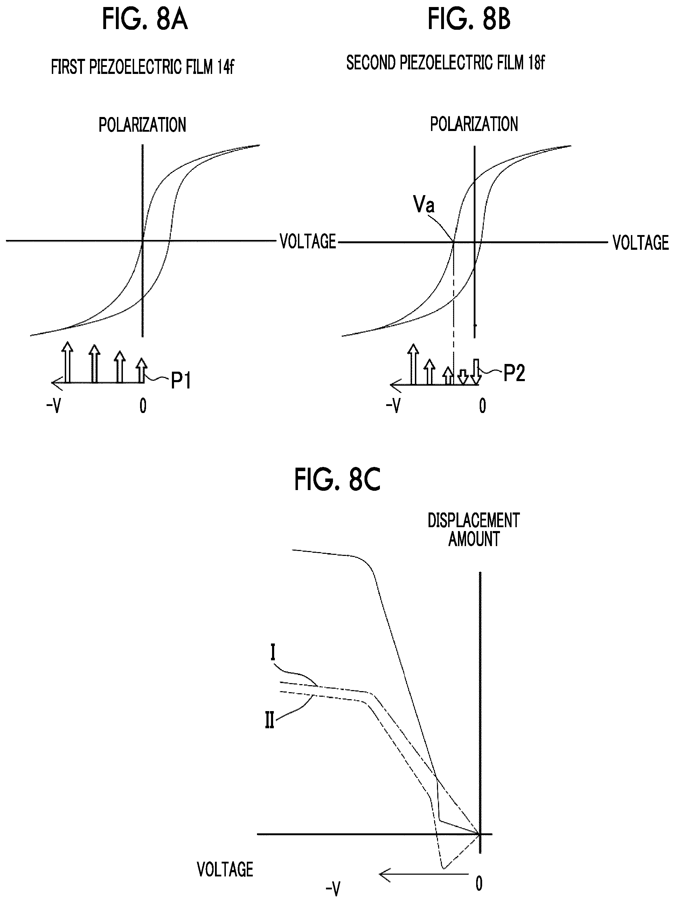

Figs. 8A and 8B show the hysteresis curves of the first piezoelectric film 14f and the second piezoelectric film 18f, respectively, in a case where the first electrode 12 and the third electrode 20 are grounded and the second electrode 16 is used as a drive electrode as shown in Fig. 7. Since the first piezoelectric film 14f and the second piezoelectric film 18f have the same composition and film thickness, in a case where the lower electrode is grounded and the upper electrode is used as the drive electrode for each piezoelectric film, both have the hysteresis curve of Fig. 8A. However, here, regarding the second piezoelectric film 18f, since the third electrode 20 which is an upper electrode is grounded and the second electrode 16 which is a lower electrode is used as a drive electrode, the hysteresis curve of Fig. 8B is a hysteresis curve obtained by rotating the hysteresis curve shown in Fig. 8A by 180° about the origin.

In a case where the potential applied to the second electrode 16 in Fig. 7 is changed from 0 to -V, an electric field in the same direction as the direction of the spontaneous polarization P1 is applied to the first piezoelectric film 14f. Therefore, as shown by arrows below the hysteresis curve in Fig. 8A, the magnitude of the polarization gradually increases in the same direction as the direction of the spontaneous polarization P1 as the potential changes from 0 to -V. Therefore, the displacement amount in a case where a voltage of 0 to -V is applied only to the first piezoelectric film 14f increases as V increases, as shown by the one-dot chain line I in Fig. 8C. In a case where the drive potential applied to the second electrode 16 in Fig. 7 is changed from 0 to -V, the electric field Er in a direction opposite to the direction of the spontaneous polarization P2 is applied to the second piezoelectric film 18f. Therefore, as shown by arrows below the hysteresis curve in Fig. 8B, as the applied potential changes from 0 to -V, the polarization in the direction of the spontaneous polarization P2 gradually decreases, and the polarization in the same direction as the electric field gradually increases after the polarization is reversed at a coercive voltage Va. Therefore, as shown by the broken line II in Fig. 8C, the displacement amount in a case where a voltage of 0 to -V is applied only to the second piezoelectric film 18f is displaced in the opposite direction up to the coercive voltage at which a value of the polarization is 0. In a case where the first piezoelectric film 14f and the second piezoelectric film 18f are driven at the same time, as shown by the solid line in Fig. 8C, they behave such that the displacement amounts of both are added. Therefore, in a case where the first piezoelectric film 14f and the second piezoelectric film 18f are driven at the same time, a very large displacement amount can be obtained on the high voltage side, but the displacement amount in the low voltage region is smaller than the displacement amount obtained with only one layer of a piezoelectric film.

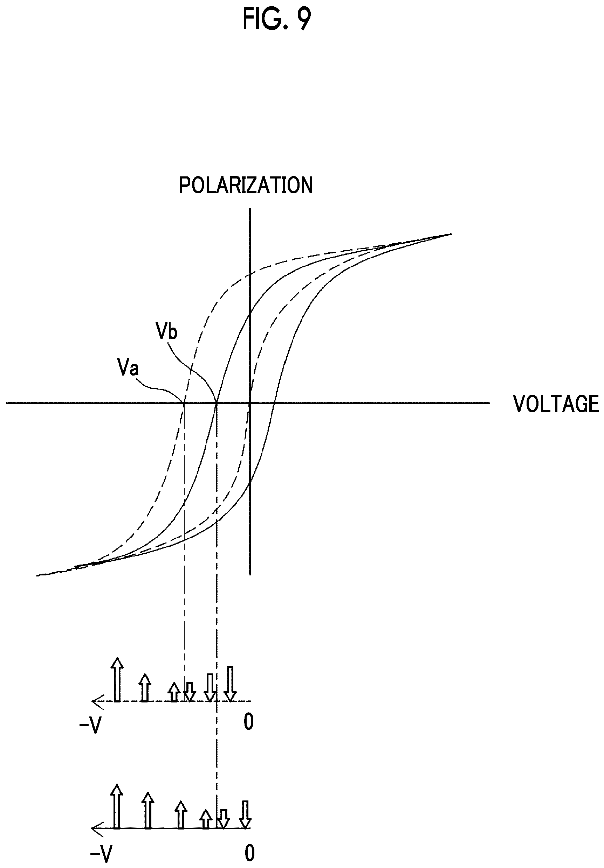

On the other hand, for example, in the piezoelectric element 1A having the configuration shown in Fig. 3, the hysteresis width of the first piezoelectric film 14r is smaller than the hysteresis width of the second piezoelectric film 18f, and the coercive voltage is small. The hysteresis curve obtained with respect to the first piezoelectric film 14r using the second electrode 16 as a drive electrode and the hysteresis curve shown in Fig. 8B are shown superimposed in Fig. 9. In Fig. 9, the hysteresis curve shown by the broken line is the hysteresis curve shown in Fig. 8B, and the hysteresis curve shown by the solid line is that of the first piezoelectric film 14r of the piezoelectric element 1A. A coercive voltage Vb of the solid line hysteresis curve is located closer to the origin side than the coercive voltage Va of the broken line hysteresis curve. That is, as shown below the hysteresis in Fig. 9, in a case where a drive voltage for applying the electric field Er in a direction opposite to the electric field Er applied to the second piezoelectric film 18f is applied to the first piezoelectric film 14r of the piezoelectric element 1A, polarization reversal occurs on the lower voltage side than in a case where a drive voltage for applying the electric field Er in a direction opposite to the electric field Ef applied to the second piezoelectric film 18f is applied to the piezoelectric film showing the broken line hysteresis curve, that is, the first piezoelectric film 14f of the piezoelectric element 101.

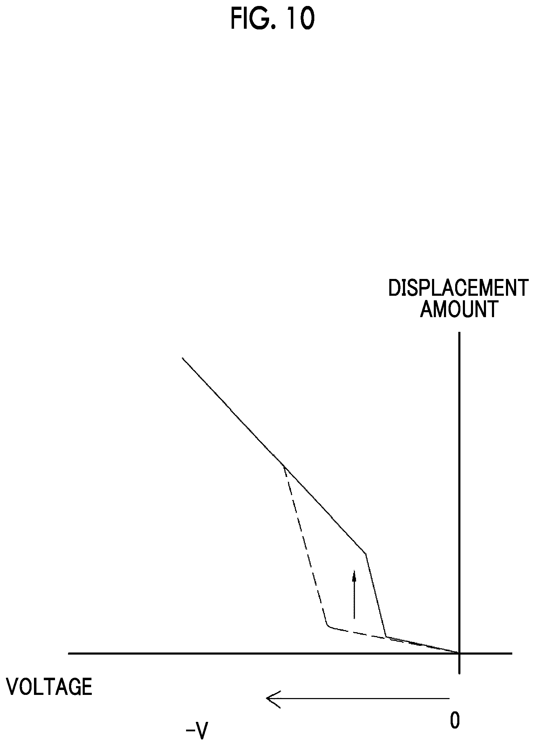

Fig. 10 shows a change in the displacement amount in a case where the piezoelectric element 101 of Fig. 7 is driven with a drive voltage of 0 to -V by the broken line and shows a change in the displacement amount in a case where the piezoelectric element 1A in Fig. 3 is driven with a drive voltage of 0 to -V by the solid line. As shown in Fig. 10, in a case where a drive voltage of 0 to -V is applied, the piezoelectric element 1A can obtain a large displacement in a low voltage region as compared with the piezoelectric element 101 of Fig. 7.

In a case where the shift amount of the hysteresis curve of the other piezoelectric film is small, the voltage (coercive voltage) at which polarization reversal occurs in a case where an electric field opposite to the direction of the spontaneous polarization is applied can be made lower as compared with a case where the shift amount is large. Therefore, it is possible to improve the piezoelectric performance in a lower voltage region.

In a case where the shift amount of the hysteresis curve of the other piezoelectric film is smaller than the shift amount of the hysteresis curve of the one piezoelectric film and the hysteresis widths of both are equal, the voltage (coercive voltage) at which polarization reversal occurs in a case where an electric field in a direction opposite to the direction of the spontaneous polarization is applied to the other piezoelectric film can be made lower as compared with a case where the shift amount is equal to or more than that of the one piezoelectric film.

Examples

Hereinafter, specific examples and comparative examples of the piezoelectric element according to the present disclosure will be described. First, a production method for a piezoelectric element of each example will be described. A radio frequency (RF) sputtering device was used for the deposition of each layer. The description of the manufacturing method will be made with reference to the references of the respective layers of the piezoelectric element 1 shown in Fig. 1.

Deposition of First Electrode

A thermal oxide film-attached silicon substrate was used as the substrate 10. The first electrode 12 was deposited on the substrate 10 by radio-frequency (RF) sputtering. Specifically, as the first electrode 12, a TiW layer having a thickness of 50 nm and an Ir layer having a thickness of 200 nm were laminated on the substrate 10 in this order. The sputtering conditions for respective layers were as follows.

Sputtering conditions for TiW layer

Distance between target and substrate: 100 mm
Target input power: 600 W
Ar gas pressure: 0.5 Pa
Set temperature of substrate: 350°C

Sputtering Conditions for Ir Layer

Distance between target and substrate: 100 mm
Target input power: 600 W
Ar gas pressure: 0.1 Pa
Set temperature of substrate: 350°C

First Piezoelectric Film

The substrate 10 with the first electrode 12 attached thereto was placed in the inside of an RF sputtering device, and an Nb-doped PZT film in which an Nb addition amount to the B site was set to 12 at% was formed as the first piezoelectric film 14. The Nb-doped PZT was used as a target, and the sputtering conditions were as follows. For Comparative Examples 1 and 2 and Examples 1 to 6, a target having a Pb composition ratio a = 1.3, a Ti/Zr molar ratio which is the MPB composition (Ti/Zr=52/48), that is, x = 0.52, and an Nb composition ratio y = 0.12 was used. For Example 7, a target having a Pb composition ratio a = 1.5 was used.

Sputtering Conditions for First Piezoelectric Film

Distance between target and substrate: 60 mm
Target input power: 500 W
Vacuum degree: 0.3 Pa, an Ar/O$_2$ mixed atmosphere (O$_2$ volume fraction: 10%)
Set temperature of substrate: 600°C to 710°C (temperature of each example was as shown in Table 1).

The film thickness of the first piezoelectric film 14 was as shown in Table 1 for each Example and Comparative Example. The film thickness was adjusted by changing a film formation time.

Second Electrode

As the second electrode 16, IrO$_z$ (z ≤ 2) of 50 nm and Ir of 100 nm were laminated on the first piezoelectric film 14 in this order. The sputtering conditions were as follows.

Sputtering Conditions for IrO$_z$ and Ir

Distance between target and substrate: 100 mm
Target input power: 200 W
Vacuum degree: 0.3 Pa, an Ar atmosphere during Ir film formation, an Ar/O$_2$ mixed atmosphere during IrO$_z$ film formation (O$_2$ volume fraction: 5%)
Set Temperature of Substrate: Room Temperature

Second Piezoelectric Film

As the second piezoelectric film 18, the Nb-doped PZT film in which the Nb addition amount to the B site was 12 at% was formed on the second electrode 16. In Comparative Example 2 and Examples 1 to 6, the same target was used for film formation of the first piezoelectric film 14 and the second piezoelectric film 18. For the first piezoelectric film 14 of Example 7, a target having a Pb composition ratio a = 1.5 was used, but for the second piezoelectric film of Example 7, a target having the Pb composition ratio a = 1.3 was used as in other examples. The film formation conditions were the same as the sputtering conditions of the first piezoelectric film except that the set temperature of substrate was set to 600°C, and the film thickness was set to 2 μm. The second piezoelectric film 18 was formed under the same sputtering conditions and film thickness for Comparative Example 2 and Examples 1 to 7. Comparative Example 1 was a piezoelectric element having a single layer of the first piezoelectric film 14 not provided with the second piezoelectric film 18 and the third electrode 20.

Third Electrode

As the third electrode 20, IrO$_z$ of 50 nm and Ir of 100 nm were laminated on the second piezoelectric film 18 in this order. The sputtering conditions were the same as those of the second electrode 16.

Formation of Electrode Pattern for Evaluation

In Comparative Example 1, in order to form electrode pads for applying a voltage to the first electrode 12 and the second electrode 16, the second electrode 16 and the first piezoelectric film 14 were sequentially patterned by photolithography and dry etching.

In Comparative Example 2 and Examples, in order to form electrode pads for applying a voltage to the first electrode 12, the second electrode 16, and the third electrode 20, the third electrode 20, the second piezoelectric film 18, the second electrode 16, and the first piezoelectric film 14 were sequentially patterned by photolithography and dry etching.

By the above process, a laminate obtained by laminating electrodes and piezoelectric layers was produced.

Measurement of Alignment Degree

The (001) plane alignment degree was determined by X-Ray diffraction (XRD) analysis using RINT-ULTIMAIII manufactured by Applied Rigaku Technologies, Inc. In an XRD chart measured for each example, the alignment degree was obtained from the intensity I(001) of the (001) plane, the intensity I(110) of the (110) plane, and the intensity I(111) of the (111) plane of a perovskite structure.

$$\text{Alignment degree} = \text{I}(001)/\{\text{I}(001) + \text{I}(110) + \text{I}(111)\} \times 100\%$$

In addition, Table 1 shows, as the alignment degree of the first piezoelectric film, the alignment degree of the first piezoelectric film 14 in a case where the alignment degree of the second piezoelectric film 18 is 100.

Measurement of Lead Amount

The Pb composition ratio for each piezoelectric film was measured by X-ray fluorescence (XRF) analysis.

Preparation of Evaluation Sample

Evaluation Sample 1

A strip-shaped portion of 2 mm $\times$ 25 mm was cut out from the laminate to prepare a cantilever as an evaluation sample 1.

Evaluation Sample 2

A portion of 25 mm $\times$ 25 mm having, at the center of the surface of the piezoelectric film, the third electrode that had been patterned in a circular shape having a diameter of 400 $\mu$m, was cut out from the laminate and used as an evaluation sample 2.

Measurement of Piezoelectric Characteristics

The piezoelectric constant $d_{31}$ was measured for the evaluation of the piezoelectric characteristics for each of Examples and Comparative Examples.
The measurement of the piezoelectric constant $d_{31}$ was carried out using the evaluation sample 1. According to a method described in I. Kanno et al., Sensor and Actuator A 107 (2003) 68, the piezoelectric constant $d_{31}$ was measured by grounding the first electrode 12 and the third electrode 20 and applying a drive signal to the second electrode 16. For each example, the piezoelectric constant $d_{31}$ was measured in a case where application voltages were -1, -3, -5, -7, -10, and -15 V, respectively. For example, the piezoelectric constant $d_{31}$ in a case where the application voltage was -1 V was measured by applying a drive signal obtained by adding a sinusoidal wave having an amplitude of 0.5 V to a bias voltage of -0.5 V to the second electrode 16. The measurement results are shown in Table 2.

Measurement of Polarization-Voltage Characteristics

For the piezoelectric elements of each Example and Comparative Example, a polarization-voltage (P-V) hysteresis curve was measured using the evaluation sample 2. The measurement was carried out by applying a voltage until saturation polarization was reached under a condition of a frequency of 1 kHz for each of the first piezoelectric film 14 and the second piezoelectric film 18 of the piezoelectric element of each Example and Comparative Example. In a case of measuring the P-V characteristics of the first piezoelectric film 14, a sweep voltage was applied to the first piezoelectric film 14 with the first electrode 12 being grounded and the second electrode 16 as a drive electrode. Further, in a case of measuring the P-V characteristics of the second piezoelectric film 18, a sweep voltage was applied to the second piezoelectric film 18 with the second electrode 16 being grounded and the third electrode 20 as a drive electrode.

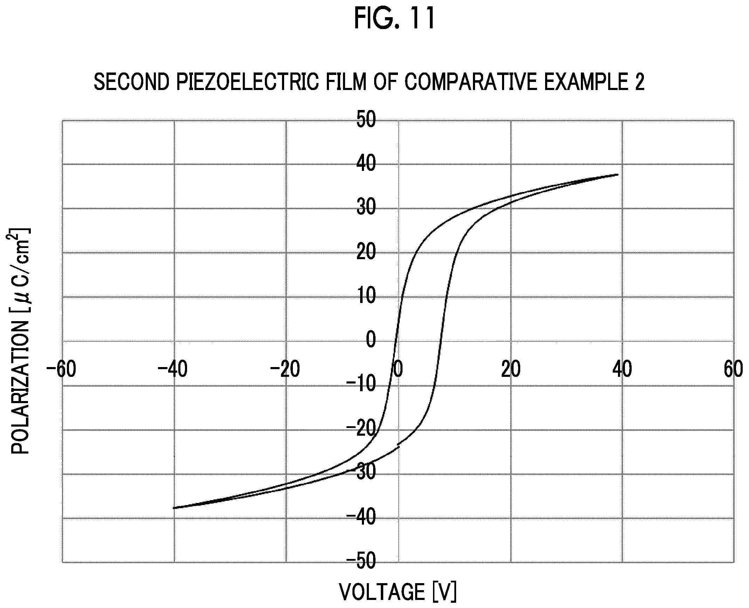

Fig. 11 is a P-V hysteresis curve for the second piezoelectric film of Comparative Example 2. All the second piezoelectric films of the piezoelectric elements of Comparative Example 2 and Examples 1 to 7 show the hysteresis characteristics shown in Fig. 11 because they are the same as the second piezoelectric film of Comparative Example 2. In the hysteresis curve shown in Fig. 11, the coercive voltage Vcf$^+$ on the positive side is 7.5 V, and the coercive voltage Vcf on the negative side is -0.5 V. Therefore, the shift amount ($|Vcf^+ + Vcf^-|$) is 3.5 V

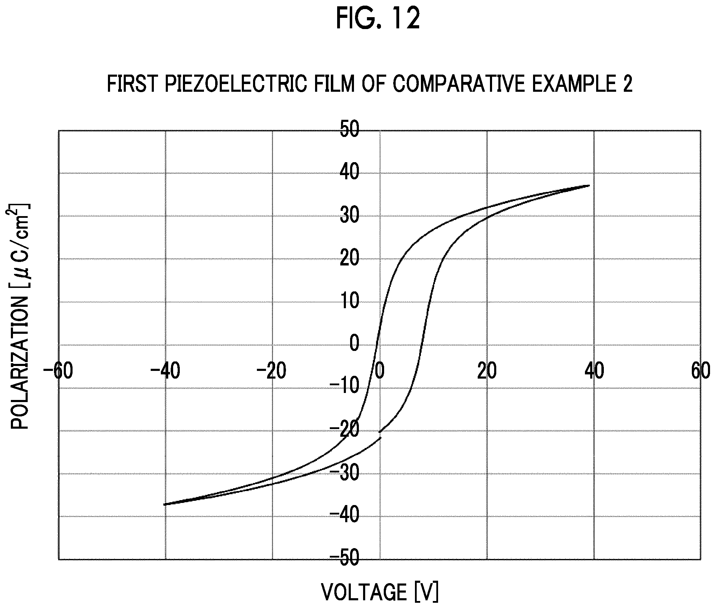

Fig. 12 is a P-V hysteresis curve obtained for the first piezoelectric film of the piezoelectric element of Comparative Example 2. In the hysteresis curve shown in Fig. 12, the coercive voltage $Vcr^+$ on the positive side is 7.7 V, and the coercive voltage $Vcr^-$ on the negative side is -0.5 V. Therefore, the shift amount is 3.6 V. Since the measured value includes an error of about $\pm 0.2$ V, the hysteresis curve shown in Fig. 12 can be regarded as substantially equivalent to the hysteresis curve shown in Fig. 11.

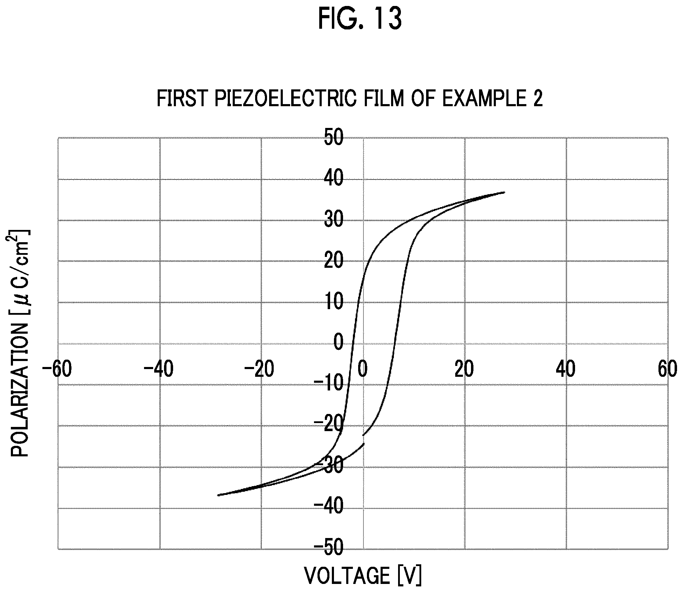

Fig. 13 is a P-V hysteresis curve obtained for the first piezoelectric film of the piezoelectric element of Example 2. In the hysteresis curve shown in Fig. 13, the coercive voltage $Vcr^+$ on the positive side is 6.1 V, and the coercive voltage $Vcr^-$ on the negative side is -2.0 V. Therefore, the shift amount is 2.1 V.

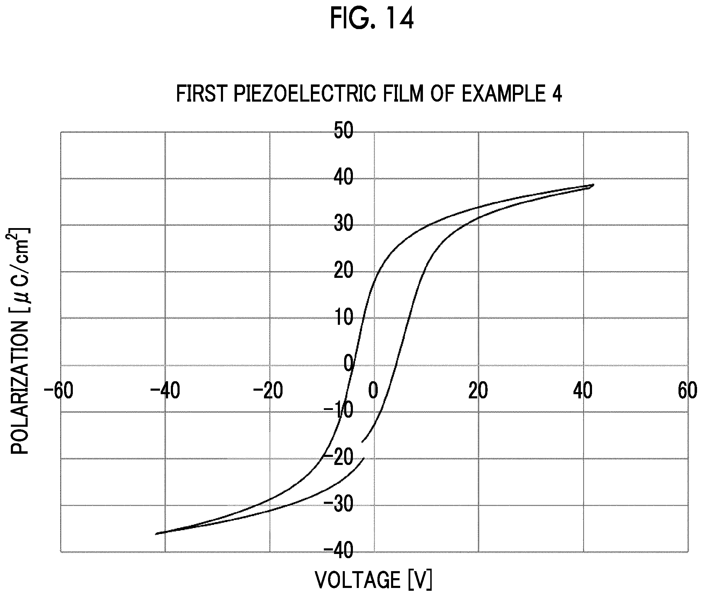

Fig. 14 is a P-V hysteresis curve obtained for the first piezoelectric film of the piezoelectric element of Example 4. In the hysteresis curve shown in Fig. 14, the coercive voltage $Vcr^+$ on the positive side is 4.1 V, and the coercive voltage $Vcr^-$ on the negative side is -3.9 V. Therefore, the shift amount is 0.1 V. This example is an example in which there is almost no shift of the hysteresis curve from the origin. It is considered that the alignment degree is low and the spontaneous polarization is almost not aligned.

Table 1 shows $Vcr^+$, $Vcr^-$, and the shift amount in the hysteresis curve of the first piezoelectric film, and $Vcf^+$, $Vcf^-$, and the shift amount in the hysteresis curve of the second piezoelectric film of the piezoelectric elements of each Example and Comparative Example, which are obtained as described above.

Table 1

| | First Piezoelectric Film | | | | | | | Second Piezoelectric Film | | | |
|---|---|---|---|---|---|---|---|---|---|---|---|
| | Deposition temperature [°C] | Lead amount | Alignment degree (with respect to second piezoelectric film) | Film thickness [μm] | $V_{cr}^{+}$ [V] | $V_{cr}^{-}$ [V] | Shift amount [V] | Film thickness [μm] | $V_{cf}^{+}$ [V] | $V_{cf}^{-}$ [V] | Shift amount [V] |
| Comparative Example 1 | 600 | 1.1 | 99.6 | 2 | 7.7 | -0.5 | 3.6 | - | - | - | - |
| Comparative Example 2 | 600 | 1.1 | 99.2 | 2 | 7.7 | -0.5 | 3.6 | 2 | 7.5 | -0.5 | 3.5 |
| Example 1 | 650 | 1.08 | 92.4 | 2 | 6.5 | -1.5 | 2.5 | 2 | 7.5 | -0.5 | 3.5 |
| Example 2 | 680 | 1.07 | 76.3 | 2 | 6.1 | -2 | 2.1 | 2 | 7.5 | -0.5 | 3.5 |
| Example 3 | 690 | 1.06 | 69.1 | 2 | 5.7 | -2.7 | 1.5 | 2 | 7.5 | -0.5 | 3.5 |
| Example 4 | 710 | 1.05 | 41.7 | 2 | 4.1 | -3.9 | 0.1 | 2 | 7.5 | -0.5 | 3.5 |
| Example 5 | 660 | 1.08 | 84.5 | 2 | 6.3 | -1.8 | 2.3 | 2 | 7.5 | -0.5 | 3.5 |
| Example 6 | 660 | 1.08 | 81.1 | 1 | 3.2 | -1 | 2.2 | 2 | 7.5 | -0.5 | 3.5 |
| Example 7 | 660 | 1.1 | 88.3 | 2 | 6.6 | -1.6 | 2.5 | 2 | 7.5 | -0.5 | 3.5 |

Table 2

| | Piezoelectric Constant $d_{31}$ (pm/V) | | | | | |
|---|---|---|---|---|---|---|
| | Application voltage -1V | Application voltage -3V | Application voltage -5V | Application voltage -7V | Application voltage -10V | Application voltage -15V |
| Comparative Example 1 | 161 | 198 | 218 | 228 | 234 | 233 |
| Comparative Example 2 | 20 | 40 | 80 | 243 | 354 | 376 |
| Example 1 | 19 | 41 | 90 | 340 | 392 | 406 |
| Example 2 | 21 | 50 | 195 | 382 | 401 | 408 |
| Example 3 | 26 | 92 | 341 | 399 | 410 | 411 |
| Example 4 | 30 | 105 | 369 | 389 | 406 | 410 |
| Example 5 | 20 | 45 | 94 | 335 | 387 | 399 |
| Example 6 | 82 | 275 | 392 | 406 | 402 | 372 |
| Example 7 | 25 | 43 | 88 | 332 | 386 | 398 |

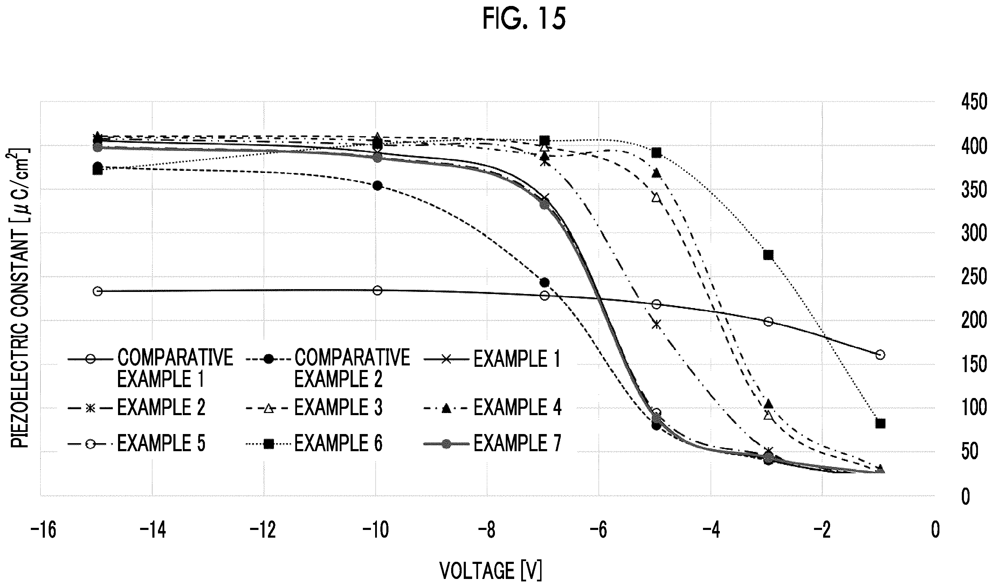

Fig. 15 is a graph showing a relationship between the application voltage and the piezoelectric constant $d_{31}$ for each piezoelectric element. In Examples 1 to 7, a piezoelectric constant larger than the piezoelectric constant $d_{31}$ of Comparative Examples 1 and 2, specifically, a piezoelectric constant which is at least 1.3 times the piezoelectric constant $d_{31}$ of Comparative Examples 1 and 2 is obtained in a case of driving at -7 V. In Comparative Example 2 comprising two layers of equivalent piezoelectric films, the piezoelectric constant $d_{31}$ at -7 V was slightly higher than the piezoelectric constant $d_{31}$ of Comparative Example 1, but the piezoelectric constant $d_{31}$ in a voltage region lower than 7 V was significantly lower than the piezoelectric constant $d_{31}$ of Comparative Example 1.

Examples 1 to 7 all satisfy $|Vcr^+ + Vcr^-| < |Vcf^+ + Vcf^-| - 0.2$.

That is, it is clear that high piezoelectric performance can be obtained in a low voltage region by comprising a piezoelectric film having a relatively large shift amount of the hysteresis curve (here, the second piezoelectric film) and a piezoelectric film having a relatively small shift amount of the hysteresis curve (here, the first piezoelectric film), applying an electric field in the same direction as the direction of the spontaneous polarization to the second piezoelectric film, and applying an electric field in a direction opposite to the electric field applied to the second piezoelectric film to the first piezoelectric film.

Example 6 is an example in which the thickness of the first piezoelectric film is thinner than that of the second piezoelectric film. In Example 6, the effect of improving the piezoelectric constant in the low voltage region was particularly high. The coercive electric field of the piezoelectric film depends on the material of the piezoelectric film. However, since the coercive voltage is the product of the coercive electric field and the film thickness, even with the same material, in a case where the film thickness is halved, the coercive voltage will be halved. As a result, it is considered that in Example 6, the coercive voltage of the first piezoelectric film could be significantly reduced, and the piezoelectric constant was significantly improved in the low voltage region.

## Claims

1.  A piezoelectric element (1) comprising:

    a substrate (10); and
    a first electrode (12), a first piezoelectric film (14), a second electrode (16), a second piezoelectric film (18), and a third electrode (20) which are provided on the substrate (10) in this order,
    wherein the first piezoelectric film (14) and the second piezoelectric film (18) contain a perovskite-type oxide represented by $Pb_a\{(Zr_xTi_{1-x})_{1-y}M_y\}O_3$, where M is a metal element selected from the group consisting of V, Nb, Ta, Sb, Mo, and W, and $0 < x < 1$, $0 < y < 1$, and $0.9 \leq a \leq 1.2$ are satisfied, as a main component,
    wherein in the first piezoelectric film (14) and the second piezoelectric film (18), at least x and y are the same, **characterized in that**:

       one piezoelectric film of the first piezoelectric film (14) and the second piezoelectric film (18) has a spontaneous polarization aligned in a film thickness direction, and **in that**

where in a hysteresis curve showing polarization-voltage characteristics of the one piezoelectric film, a coercive voltage on a positive side is denoted by $Vcf^+$ and a coercive voltage on a negative side is denoted by $Vcf^-$, and in a hysteresis curve showing polarization-voltage characteristics of the other piezoelectric film of the first piezoelectric film (14) and the second piezoelectric film (18), a coercive voltage on a positive side is denoted by $Vcr^+$ and a coercive voltage on a negative side is denoted by $Vcr^-$, $|Vcr^+ + Vcr^-| < |Vcf^+ + Vcf^-| - 0.2$, where units are all [V], is satisfied.

2.  The piezoelectric element (1) according to claim 1, wherein $|Vcr^+ + Vcr^-| \leq |Vcr^+ - Vcr^-|$ is further satisfied.

3.  The piezoelectric element (1) according to claim 1 or 2, wherein the other piezoelectric film has a spontaneous polarization aligned in the film thickness direction, and
    directions of the spontaneous polarizations of the one piezoelectric film and the other piezoelectric film are the same.

4.  The piezoelectric element (1) according to any one of claims 1 to 3, wherein an electric field in the same direction as a direction of the spontaneous polarization of the one piezoelectric film is configured to be applied to the one piezoelectric film, and an electric field in a direction opposite to the electric field applied to the one piezoelectric film is configured to be applied to the other piezoelectric film.

5.  The piezoelectric element (1) according to any one of claims 1 to 4, wherein a hysteresis width defined by an interval between two coercive voltages in the hysteresis curve showing polarization-voltage characteristics of the one piezoelectric film is equal to the hysteresis width of the other piezoelectric film.

6.  The piezoelectric element (1) according to any one of claims 1 to 5, where a (001) plane alignment degree of the one piezoelectric film is denoted by $\alpha$, a (001) plane alignment degree of the other piezoelectric film is $0.95\alpha$ or less.

7.  The piezoelectric element (1) according to any one of claims 1 to 5, where a (001) plane alignment degree of the one piezoelectric film is denoted by $\alpha$, a (001) plane alignment degree of the other piezoelectric film is $0.80\alpha$ or less.

8.  The piezoelectric element (1) according to any one of claims 1 to 7, wherein the first electrode (12) and the third electrode (20) are connected to each other.

9.  The piezoelectric element (1) according to any one of claims 1 to 8, wherein the metal element M is Nb and y is greater than 0.1.

10. An actuator (5, 6, 7) comprising:

    the piezoelectric element (1) according to any one of claims 1 to 9; and
    a drive circuit (30, 32, 34) that is configure to apply a drive voltage to the piezoelectric element,
    wherein the drive circuit (30, 32, 34) is configured to apply an electric field in the same direction as a direction of the spontaneous polarization of the one piezoelectric film to the one piezoelectric film, and is configured to apply an electric field in a direction opposite to the electric field applied to the one piezoelectric film to the other piezoelectric film.

**Patentansprüche**

1.  Piezoelektrisches Element (1), umfassend:

    ein Substrat (10); und
    eine erste Elektrode (12), einen ersten piezoelektrischen Film (14), eine zweite Elektrode (16), einen zweiten piezoelektrischen Film (18) und eine dritte Elektrode (20), die in dieser Reihenfolge auf dem Substrat (10) bereitgestellt sind,
    wobei der erste piezoelektrische Film (14) und der zweite piezoelektrische Film (18) ein Oxid vom Perowskit-Typ enthalten, das durch $Pb_a\{(Zr_xTi_{1-x})_{1-y}M_y\}O_3$ dargestellt ist, wobei M ein Metallelement ist, das aus der Gruppe ausgewählt ist, die aus V, Nb, Ta, Sb, Mo und W besteht, und $0 < x < 1$, $0 < y < 1$ und $0,9 \leq a \leq 1,2$ als eine Hauptkomponente erfüllt sind,
    wobei in dem ersten piezoelektrischen Film (14) und dem zweiten piezoelektrischen Film (18) mindestens x und y gleich sind, **dadurch gekennzeichnet, dass**:

ein piezoelektrischer Film des ersten piezoelektrischen Films (14) und des zweiten piezoelektrischen Films (18) eine spontane Polarisation aufweist, die in einer Filmdickenrichtung ausgerichtet ist, und dadurch, dass in einer Hysteresekurve, die Polarisationsspannungseigenschaften des einen piezoelektrischen Films zeigt, eine Koerzitivspannung auf einer positiven Seite mit $Vcf^+$ bezeichnet ist und eine Koerzitivspannung auf einer negativen Seite mit $Vcf^-$ bezeichnet ist und in einer Hysteresekurve, die Polarisationsspannungseigenschaften des anderen piezoelektrischen Films des ersten piezoelektrischen Films (14) und des zweiten piezoelektrischen Films (18) zeigt, eine Koerzitivspannung auf einer positiven Seite mit $Vcr^+$ bezeichnet ist und eine Koerzitivspannung auf einer negativen Seite mit $Vcr^-$ bezeichnet ist, wobei $|Vcr^+ + Vcr^-| < |Vcf^+ + Vcf^-| - 0{,}2$ erfüllt ist, wobei alle Einheiten [V] sind.

2.  Piezoelektrisches Element (1) nach Anspruch 1, wobei ferner $|Vcr^+ + Vcr^-| \leq |Vcr^+ - Vcr^-|$ erfüllt ist.

3.  Piezoelektrisches Element (1) nach Anspruch 1 oder 2, wobei der andere piezoelektrische Film eine spontane Polarisation aufweist, die in der Filmdickenrichtung ausgerichtet ist, und
Richtungen der spontanen Polarisationen des einen piezoelektrischen Films und des anderen piezoelektrischen Films gleich sind.

4.  Piezoelektrisches Element (1) nach einem der Ansprüche 1 bis 3, wobei ein elektrisches Feld in derselben Richtung wie eine Richtung der spontanen Polarisation des einen piezoelektrischen Films dazu konfiguriert ist, an dem einen piezoelektrischen Film angelegt zu werden, und ein elektrisches Feld in einer dem an dem einen piezoelektrischen Film angelegten elektrischen Feld entgegengesetzten Richtung dazu konfiguriert ist, an dem anderen piezoelektrischen Film angelegt zu werden.

5.  Piezoelektrisches Element (1) nach einem der Ansprüche 1 bis 4, wobei eine Hysteresebreite, die durch ein Intervall zwischen zwei Koerzitivspannungen in der Hysteresekurve, die Polarisationsspannungseigenschaften des einen piezoelektrischen Films zeigt, definiert ist, gleich der Hysteresebreite des anderen piezoelektrischen Films ist.

6.  Piezoelektrisches Element (1) nach einem der Ansprüche 1 bis 5, wobei ein (001)-Ebenenausrichtungsgrad des einen piezoelektrischen Films durch $\alpha$ bezeichnet ist, wobei ein (001)-Ebenenausrichtungsgrad des anderen piezoelektrischen Films $0{,}95\alpha$ oder weniger beträgt.

7.  Piezoelektrisches Element (1) nach einem der Ansprüche 1 bis 5, wobei ein (001)-Ebenenausrichtungsgrad des einen piezoelektrischen Films durch $\alpha$ bezeichnet ist, wobei ein (001)-Ebenenausrichtungsgrad des anderen piezoelektrischen Films $0{,}80\alpha$ oder weniger beträgt.

8.  Piezoelektrisches Element (1) nach einem der Ansprüche 1 bis 7, wobei die erste Elektrode (12) und die dritte Elektrode (20) miteinander verbunden sind.

9.  Piezoelektrisches Element (1) nach einem der Ansprüche 1 bis 8, wobei das Metallelement M Nb ist und y größer als 0,1 ist.

10. Aktuator (5, 6, 7), umfassend:

das piezoelektrische Element (1) nach einem der Ansprüche 1 bis 9; und
eine Antriebsschaltung (30, 32, 34), die dazu konfiguriert ist, eine Antriebsspannung an das piezoelektrische Element anzulegen,
wobei die Antriebsschaltung (30, 32, 34) dazu konfiguriert ist, an dem einen piezoelektrischen Film ein elektrisches Feld in derselben Richtung wie eine Richtung der spontanen Polarisation des einen piezoelektrischen Films anzulegen, und dazu konfiguriert ist, an dem anderen piezoelektrischen Film ein elektrisches Feld in einer dem an dem einen piezoelektrischen Film angelegten elektrischen Feld entgegengesetzten Richtung anzulegen.

**Revendications**

1.  Élément piézoélectrique (1) comprenant :

un substrat (10) ; et

une première électrode (12), un premier film piézoélectrique (14), une deuxième électrode (16), un second film piézoélectrique (18) et une troisième électrode (20) qui sont disposés sur le substrat (10) dans cet ordre,

dans lequel le premier film piézoélectrique (14) et le second film piézoélectrique (18) contiennent un oxyde de type pérovskite représenté par $Pb_a\{(Zr_xTi_{1-x})_{1-y}M_y\}O_3$, où M est un élément métallique choisi dans le groupe constitué de V, Nb, Ta, Sb, Mo et W, et $0 < x < 1$, $0 < y < 1$ et $0,9 \leq a \leq 1,2$ sont satisfaites, en tant que composant principal,

dans lequel, dans le premier film piézoélectrique (14) et le second film piézoélectrique (18), au moins x et y sont identiques, **caractérisé en ce que** :

un film piézoélectrique du premier film piézoélectrique (14) et du second film piézoélectrique (18) présente une polarisation spontanée alignée selon une direction d'épaisseur de film, et **en ce que**

où, dans une courbe d'hystérésis montrant des caractéristiques de polarisation-tension de l'un film piézoélectrique, une tension coercitive sur un côté positif est désignée par Vcf$^+$ et une tension coercitive sur un côté négatif est désignée par Vcf, et dans une courbe d'hystérésis montrant des caractéristiques de polarisation-tension de l'autre film piézoélectrique du premier film piézoélectrique (14) et du second film piézoélectrique (18), une tension coercitive sur un côté positif est désignée par Vcr$^+$ et une tension coercitive sur un côté négatif est désignée par Vcr$^-$, $|Vcr^+ + Vcr^-| < |Vcf^+ + Vcf^-| - 0,2$, où les unités sont toutes [V], est satisfaite.

2. Élément piézoélectrique (1) selon la revendication 1, dans lequel $|Vcr^+ + Vcr^-| \leq |Vcr^+ - Vcr^-|$ est en outre satisfaite.

3. Élément piézoélectrique (1) selon la revendication 1 ou 2, dans lequel l'autre film piézoélectrique présente une polarisation spontanée alignée dans la direction d'épaisseur de film, et

les directions des polarisations spontanées de l'un film piézoélectrique et de l'autre film piézoélectrique sont les mêmes.

4. Élément piézoélectrique (1) selon l'une quelconque des revendications 1 à 3, dans lequel un champ électrique dans la même direction qu'une direction de la polarisation spontanée de l'un film piézoélectrique est configuré pour être appliqué à l'un film piézoélectrique, et un champ électrique dans une direction opposée au champ électrique appliqué à l'un film piézoélectrique est configuré pour être appliqué à l'autre film piézoélectrique.

5. Élément piézoélectrique (1) selon l'une quelconque des revendications 1 à 4, dans lequel une largeur d'hystérésis définie par un intervalle entre deux tensions coercitives dans la courbe d'hystérésis montrant des caractéristiques de polarisation-tension de l'un film piézoélectrique est égale à la largeur d'hystérésis de l'autre film piézoélectrique.

6. Élément piézoélectrique (1) selon l'une quelconque des revendications 1 à 5, où un degré d'alignement de plan (001) de l'un film piézoélectrique est désigné par $\alpha$, un degré d'alignement de plan (001) de l'autre film piézoélectrique est de $0,95\alpha$ ou moins.

7. Élément piézoélectrique (1) selon l'une quelconque des revendications 1 à 5, où un degré d'alignement de plan (001) de l'un film piézoélectrique est désigné par $\alpha$, un degré d'alignement de plan (001) de l'autre film piézoélectrique est de $0,80\alpha$ ou moins.

8. Élément piézoélectrique (1) selon l'une quelconque des revendications 1 à 7, dans lequel la première électrode (12) et la troisième électrode (20) sont reliées l'une à l'autre.

9. Élément piézoélectrique (1) selon l'une quelconque des revendications 1 à 8, dans lequel l'élément métallique M est Nb et y est supérieur à 0,1.

10. Actionneur (5, 6, 7) comprenant :

l'élément piézoélectrique (1) selon l'une quelconque des revendications 1 à 9 ; et

un circuit de commande (30, 32, 34) qui est configuré pour appliquer une tension de commande à l'élément piézoélectrique,

dans lequel le circuit de commande (30, 32, 34) est configuré pour appliquer un champ électrique dans la même direction qu'une direction de la polarisation spontanée de l'un film piézoélectrique à l'un film piézoélectrique, et est configuré pour appliquer un champ électrique dans une direction opposée au champ électrique appliqué à l'un film piézoélectrique à l'autre film piézoélectrique.

# FIG. 1

# FIG. 2A

# FIG. 2B

# FIG. 3

# FIG. 4

# FIG. 5

# FIG. 6

# FIG. 7

# FIG. 8A

FIRST PIEZOELECTRIC FILM 14f

POLARIZATION

VOLTAGE

P1

-V　　0

# FIG. 8B

SECOND PIEZOELECTRIC FILM 18f

POLARIZATION

Va

VOLTAGE

P2

-V　　0

# FIG. 8C

DISPLACEMENT
AMOUNT

I

II

VOLTAGE

-V　　0

# FIG. 9

# FIG. 10

# FIG. 11

## SECOND PIEZOELECTRIC FILM OF COMPARATIVE EXAMPLE 2

EP 4 346 360 B1

FIG. 12

FIRST PIEZOELECTRIC FILM OF COMPARATIVE EXAMPLE 2

VOLTAGE [V]

POLARIZATION [μC/cm²]

FIG. 13

FIG. 14

FIG. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013080886 A
- JP 2013080887 A
- WO 2007112741 A1
- JP 2017130701 A

**Non-patent literature cited in the description**

- **I. KANNO et al.** *Sensor and Actuator A*, 2003, vol. 107